# EUROPEAN PATENT SPECIFICATION

(11) **EP 3 972 231 B1**
(45) Date of publication and mention of the grant of the patent: **07.06.2023**
(21) Application number: 20808855.9
(22) Date of filing: 09.05.2020
(51) Int. Cl.: H04M 1/03, H04M 1/02

(54) **SCREEN ASSEMBLY, MIDDLE FRAME, AND TERMINAL DEVICE**
SCHIRMANORDNUNG, MITTELRAHMEN UND ENDGERÄT
ENSEMBLE ÉCRAN, CADRE INTERMÉDIAIRE, ET DISPOSITIF TERMINAL

(30) Priority: 23.05.2019 CN 201920758066 U
(43) Date of publication of application: 23.03.2022
(73) Proprietor: GUANGDONG OPPO MOBILE TELECOMMUNICATIONS CORP., LTD., Dongguan, Guangdong 523860 (CN)
(72) Inventor: GONG, Guan, Dongguan, Guangdong 523860 (CN); WEN, Quanhao, Dongguan, Guangdong 523860 (CN)
(74) Representative: Mewburn Ellis LLP
(86) International application number: PCT/CN2020/089396
(87) International publication number: WO 2020/233426

(56) References cited:
- EP-A1- 3 910 921
- EP-B1- 2 629 496
- CN-A- 107 508 939
- CN-A- 107 734 092
- CN-A- 108 924 304

## Description

### TECHNICAL FIELD

This disclosure relates to the technical field of terminal devices, and in particular to a screen assembly, a frame, and a terminal device.

### BACKGROUND

With increasing development of terminal device technology, people hope that more devices can be integrated in a mobile phone to achieve more diverse functions. However, with more and more devices being installed in a terminal device, the body of the terminal device is getting bigger and bigger, thus a light and thin design of the terminal device is hindered and the terminal device is unable to meet needs of a user.

CN 107734092 A discloses a mobile terminal comprising a main display screen, a frame and a rear shell, wherein the material of the frame includes at least one of metal or plastic, the main display screen and the rear shell are separately arranged on two sides of the frame, and sound holes are formed in the frame.

CN 107508939 A discloses communication equipment that comprises a case, a display screen component and an ultrasonic sensor arranged in the case. The ultrasonic sensor comprises an emitter and a receiver arranged in the case. The communication equipment is provided with an emitting port matched with the emitter and a receiving port matched with the receiver, wherein at least one of the emitting port and the receiving port is a micro crack formed between the case and the display screen component.

### SUMMARY

Aspects of the invention are set out in the appended claims.

A terminal device is provided in implementations of the present disclosure. The terminal device includes a frame having a front side surface. The front side surface includes a first surface and a second surface adjacent to the first surface along a thickness direction of the frame. The second surface is recessed relative to the first surface. The first surface defines a groove. The second surface defines a notch extending through the bottom of the groove, and the notch of the frame forms the sound outlet channel for the sound signals of the receiver to pass through. The screen assembly is disposed on the front side surface and is configured to cover the notch of the frame.

In the terminal device provided in implementations of the present disclosure, the screen assembly is configured to cover the notch, the frame defines the groove on the top, such that the sounds of the receiver can be transmitted to the outside. In addition, while a user is looking directly at the screen assembly (i.e., a user is looking at the screen assembly in a thickness direction of the terminal device), because the notch is covered by the screen assembly, a receiver hole for the receiver to transmit the sound signals to the outside is unable to be perceived, such that the terminal device has a visual effect that there is no receiver hole.

### BRIEF DESCRIPTION OF THE DRAWINGS

In order to describe technical solutions of the present disclosure more clearly, the following will briefly introduce accompanying drawings which are needed to be used in the implementations. Apparently, the accompanying drawings described below are merely some implementations. Those of ordinary skill in the art can also obtain other accompanying drawings based on the accompanying drawings described below without creative efforts.
FIG. 1 is a schematic stereoscopic structural view of a terminal device according to implementations of the present disclosure.
FIG. 2 is a schematic stereoscopic structural view of the terminal device in FIG. 1 from another angle.
FIG. 3 is an exploded schematic view of a frame and a screen assembly of the terminal device in FIG. 2.
FIG. 3a is a partial schematic view of the frame of the terminal device in FIG. 3.
FIG. 4 is a partial enlarged schematic view of the terminal device at Circle IV in FIG. 2.
FIG. 5 is a schematic stereoscopic structural view of the frame of the terminal device in FIG. 3 from another angle.
FIG. 6 is a schematic cross-sectional view of the terminal device in FIG. 2, taken along line A-A.
FIG. 7 is a partial enlarged schematic view of the terminal device at Circle VIII in FIG. 6.
FIG. 8 is a schematic cross-sectional view of the terminal device in FIG. 2, taken along line A-A, according to other implementations of the present disclosure.
FIG. 9 is a partial enlarged schematic view of the terminal device at Circle VIV in FIG. 8.
FIG. 10 is a schematic cross-sectional view of the terminal device in FIG. 2, taken along line B-B.
FIG. 11 is a schematic cross-sectional view of the terminal device in FIG. 2 where a resilient piece can be shown.

### DETAILED DESCRIPTION

The following will give a clear and complete description to technical solutions of implementations in present disclosure, with reference to accompanying drawings of implementations in present disclosure.

In order to understand above-mentioned purposes, features, and advantages of the present disclosure more clearly, the following will describe the present disclosure in connection with the accompanying drawings and the implementations in detail. Various implementations and features of the various implementations may be implemented in combination with each other without conflict.

In the following description, many specific details are elaborated to facilitate a full understanding of the present disclosure. Implementations described herein are merely some implementations, rather than all implementations, of the present disclosure. Based on the implementations described herein, all other implementations obtained by those of ordinary skill in the art without creative effort shall fall within the protection scope of the disclosure.

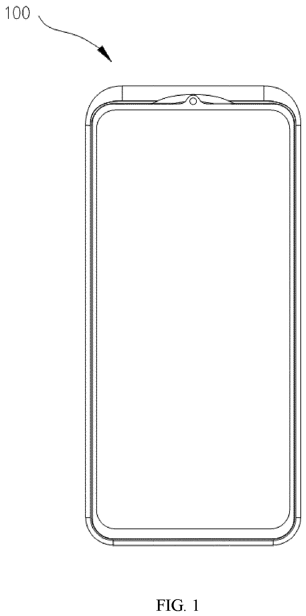

FIG. 1 is a schematic stereoscopic structural view of a terminal device 100 according to implementations of the present disclosure. The terminal device 100 may be a communication terminal configured to communicate via a wireless interface and may be called a "wireless communication terminal", a "wireless terminal", or a "mobile terminal". The "communication terminal" (or "terminal") described herein can include but is not limited to a device configured via a wired line and/or a wireless interface to receive/transmit communication signals. The wired line may include, but is not limited to, at least one of: a public switched telephone network (PSTN), a digital subscriber line (DSL), a digital cable, a direct connection cable, and/or another data connection/ data network. The wireless interface may be for at least one of: a cellular network, a wireless local area network (WLAN), a digital television network (such as a digital video broadcasting-handheld (DVB-H) network), a satellite network, an amplitude modulation (AM)- frequency modulation (FM) broadcast transmitter, and/or another communication terminal. The terminal device 100 may include, but are not limited to, a satellite or cellular telephone; a personal communication system (PCS) terminal capable of cellular radio telephone, data processing, fax, and/or data communication, a personal digital assistant (PDA) equipped with radio telephone, pager, Internet/Intranet access, web browsing, notebook, calendar, and/or global positioning system (GPS) receiver; a conventional laptop or a handheld receiver; and/or other electronic devices equipped with radio telephone receiver.

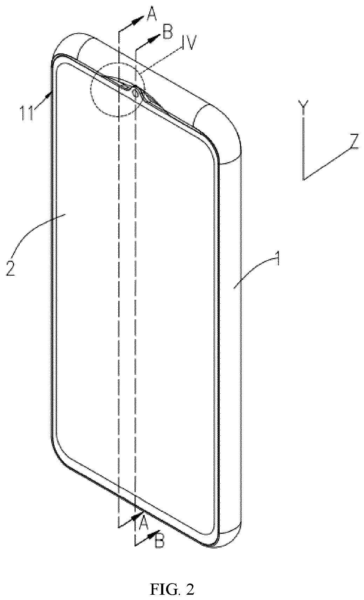

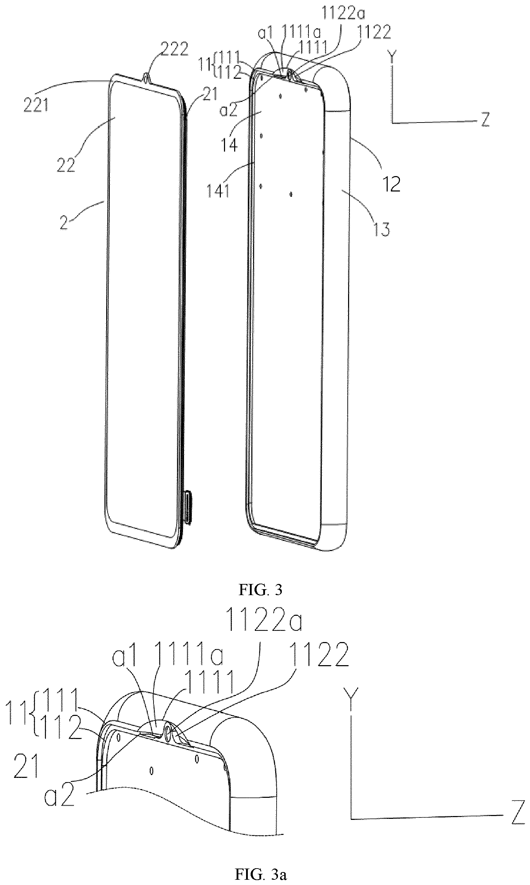

FIG. 2 is a schematic stereoscopic structural view of the terminal device in FIG. 1 from another angle. As illustrated in FIG. 2, the terminal device 100 includes a frame 1 and a screen assembly 2. The frame 1 has a front side surface 11 and a back side surface 12 opposite to the front side surface 11. FIG. 3 is exploded schematic view of a frame and a screen assembly of the terminal device in FIG. 2. FIG. 3a is a partial schematic view of the frame of the terminal device in FIG. 3. As illustrated in FIG. 3 and FIG. 3a, the front side surface 11 has a first surface 111 and a second surface 112 adjacent to the first surface along a thickness direction Z of the frame 1. That the first surface 111 and the second surface 112 are adjacent may be that the first surface 111 is connected with the second surface 112 directly, and may also be that the first surface 111 is connected with the second surface 112 via another surface. In this implementation, that the first surface 111 is connected with the second surface 112 via another surfaces is taken as an example to explain. The first surface 111 and the second surface 112 face the screen assembly 2.

The second surface 112 is recessed relative to the first surface 111. In other words, the second surface 112 is further away from the screen assembly 2 relative to the first surface 111 (i.e., the second surface 112 is closer to a back side surface 12 relative to the first surface 111). The first surface 111 defines a groove 1111.

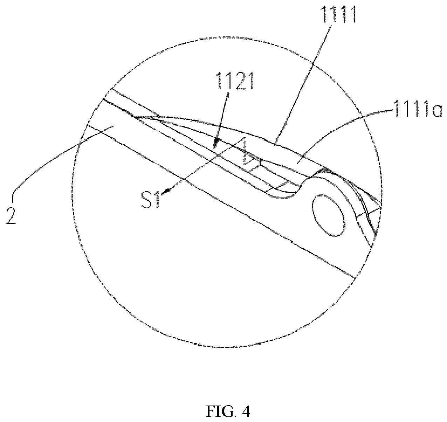

FIG. 4 is a partial enlarged schematic view of the terminal device at Circle IV in FIG. 2. As illustrated in FIG. 4, the second surface 112 defines a notch 1121 which extends through the bottom 1111a of the groove 1111, such that the notch 1121 is connected with the groove 1111. The notch 1121 of the frame 1 forms a sound outlet channel for sound signals S1 of a receiver 3 to pass through. The screen assembly 2 is disposed on the front side surface 11 and is configured to cover the notch 1121. As an implementation, the bottom 1111a of the groove 1111 may be a concave arc surface. The bottom 1 11 1a of the groove 1111 is the concave arc surface, such that most of the sound signals S1 can reach the bottom 1111a of the groove 1111 and can be reflected to the outside by the bottom 1111a of the groove 1111. In addition, the groove 1111 has a visual effect of a less groove depth, and the groove depth is a distance of the groove 1111 along the thickness direction Z of the terminal device 100. As other implementations, the bottom 1111a of the groove 1111 may be a plane parallel to a X-Y plane (where a direction X is a width direction of the terminal device 100 and a direction Y is a length direction of the terminal device 100), and may also be an inclined surface relative to the X-Y plane.

As an implementation, as illustrated in FIG. 3, the frame 1 is a frame body. The front side surface 11 of the frame 1 is connected with the screen assembly 2, the back side surface 12 of the frame 1 is connected with a back plate, so as to form an enclosed housing of the terminal device 100. In other words, the front side surface 11 and the back side surface 12 are two edge surfaces which are opposite to each other to define an opening on the frame 1. The frame 1 defines a chamber which is configured to accommodate various devices, such as a camera, a receiver 3, a circuit board, and the like. The frame 1 includes an exterior side surface 13 which is connected between the front side surface 11 and the back side surface 12. The exterior side surface 13 is an arc surface, so as to make the frame 1 smooth, avoid stress concentration, and facilitate the user to hold. As other implementations, the frame 1 may be a structure where the back side surface 12 and the back plate are integrally connected.

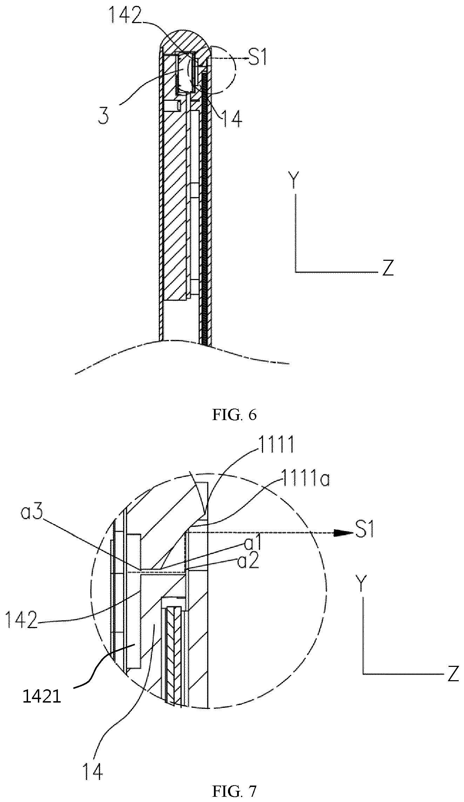

As illustrated in FIG. 3 and FIG. 3a, the second surface 112 defines the notch 1121, and two openings are defined along the thickness direction Z. For ease of description, the two openings are respectively defined as a first opening a1 and a second opening a2. The first opening a1 is defined in the bottom 1111a of the groove 1111 and the second opening a2 is close to the screen assembly 2. After the screen assembly 2 is disposed on the front side surface 11, the screen assembly can be configured to cover the second opening a2. Because of the groove 1111, air from outside can enter the notch 1121 via the groove 1111 and get out via the first opening a1, and the first opening a1 can still be connected with the outside and will not be blocked. As such, as illustrated in FIG. 6, the sound signals S 1 of the receiver 3 can pass through the first opening a1 and reach the bottom 1111a of the groove 1111, then the sound signals S1 can be reflected to the outside by the bottom 1111a of the groove 1111, thus a receiving function of the receiver 3 can be achieved.

The screen assembly 2 is configured to cover the notch 1121, the frame 1 defines the groove 1111 on the top, such that sounds of the receiver 3 can be transmitted to the outside. In addition, while the user is looking directly at (i.e., the user is looking squarely at) the screen assembly 2 as shown in FIG. 1 (i.e., the user is looking at the screen assembly in a thickness direction of the terminal device), because the notch 1121 is covered by the screen assembly 2, a receiver hole for the receiver 3 to transmit the sound signals S1 to the outside is unable to be perceived, such that the terminal device 100 has a visual effect that there is no receiver hole.

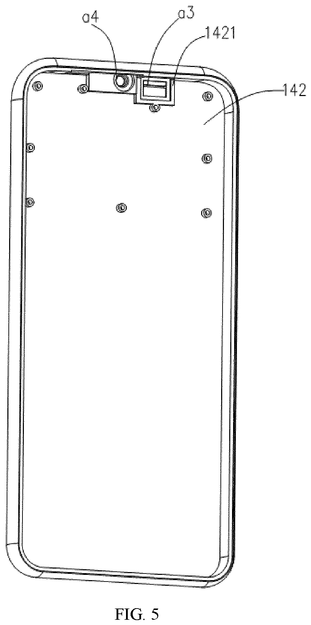

As illustrated in FIG. 3, the front side surface 11 is a step surface. In other words, the second surface 112 is sinking relative to the first surface 111 along the thickness direction Z of the frame 1 to form the step surface. The first surface 111 can be configured to be connected with the exterior side surface 13 of the terminal device 100. While the user is using the terminal device 100, the user can put fingers on the exterior side surface 13 to hold the terminal device 100. As another implementation, as illustrated in FIG. 3 and FIG. 5, the terminal device 100 further includes a supporting plate 14 which has a third surface 141 and a fourth surface 142 opposite to the third surface 141. The third surface 141 faces the screen assembly 2 and is recessed relative to the second surface 112. The notch 1121 extends through the supporting plate 14. When the screen assembly 2 is disposed on the front side surface 11, a display screen 21 of the screen assembly 2 is totally attached to the third surface 141, a cover plate 22 of the screen assembly 2 is disposed on the second surface 112 and is configured to cover the notch 1121. Furthermore, the terminal device 100 is provided with the supporting plate 14 and the third surface 141 of the supporting plate 14 can support the display screen 21. An edge of the display screen 21 is flush with an edge of the third surface 141, an edge of the cover plate 22 is flush with an edge of the second surface 112 which is connected with the first surface 111, thus an entire screen assembly 2 can be received in the frame 1. When the terminal device 100 is impacted, the frame 1 can protect the screen assembly 2, therefore, reliability of the terminal device 100 can be improved.

FIG. 6 is a schematic cross-sectional view of the terminal device in FIG. 2, taken along line A-A. As illustrated in FIG. 6, the terminal device 100 further includes the receiver 3. The receiver 3 is disposed on the fourth surface 142. The receiver 3 defines a front sound chamber aligned with the sound outlet channel. Once the sound signals S1 are generated at the receiver 3, at least part of the sound signals of the receiver 3 pass through the notch 1121 and are reflected to the outside by the bottom 1111a of the groove 1111.

FIG. 7 is a partial enlarged schematic view of the terminal device at Circle VIII in FIG. 6. As illustrated in FIG. 7, the fourth surface 142 is disposed opposite to the third surface 141. The fourth surface 142 is provided with a receiving portion 1421 which is configured to fix the receiver 3. The receiving portion 1421 defines a chamber which is configured to receive the receiver 3. Since the notch 1121 extends to the fourth surface 142, an opening on the fourth surface 142 is defined as a third opening a3. The receiver 3 defines the front sound chamber aligned with the third opening a3. As such, the sound signals S1 of the receiver 3 are transmitted to the bottom 1111a of the groove 1111 via the third opening a3, the first opening a1, the second opening a2 in sequence, and are reflected to the outside by the bottom 1111a of the groove 1111, so as to achieve the receiving function of the receiver 3. When the sound signals S1 of the receiver 3 needs to be transmitted to the outside, the sound signals S1 pass through the third opening a3 and the first opening a1 in sequence along a first direction (a rightward direction in FIG. 7) and are blocked by the cover plate 22, after that, the sound signals S1 bypass the cover plate 22, that is, the sound signals S1 are transmitted along a second direction (an upward direction in FIG. 7), reach the bottom 1111a of the groove 1111, are reflected to the outside by the bottom 1111a of the groove 1111, thus the receiving function of the receiver 3 can be achieved. The first direction is the thickness direction Z of the terminal device 100 and the second direction is a length direction Y of the terminal device 100. In other words, the sound signals S1 of the receiver 3 are transmitted along the thickness direction Z and then along the length direction Y, after that the sound signals S1 are reflected by the bottom 1111a of the groove 1111 and transmitted along the thickness direction Z. As such, the sound signals S1 can enter the user's ear in the thickness direction Z, when the user's ear is attached to the front side surface 11 of the terminal device 100. Because the sound signals S1 can automatically bypass an obstacle, not all of the sound signals S1 are transmitted to the outside of the terminal device 100 via the above pathway. In other words, some of the sound signals S1 are transmitted along the first direction and may reach the bottom 1111a of the groove 1111 directly instead of reaching the cover plate 22, and then the some of the sound signals S1 may be reflected to the outside of the terminal device 1000 by the bottom 1111a of the groove 1111.

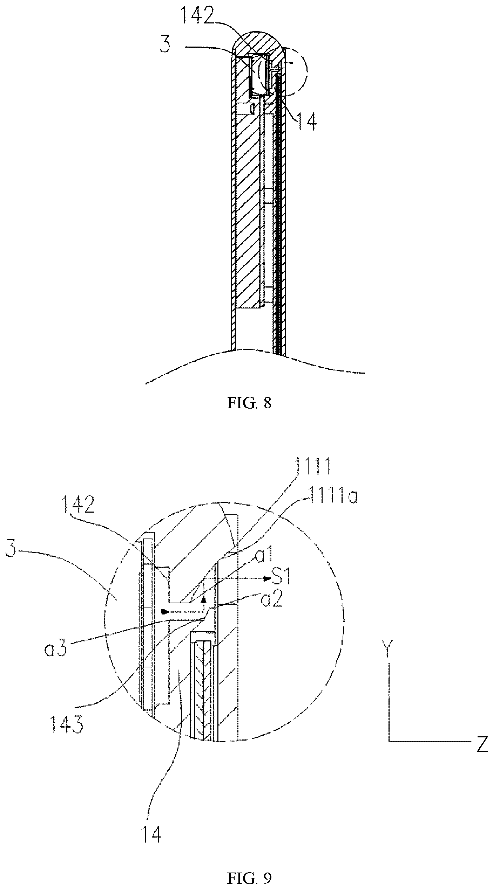

FIG. 8 is a schematic cross-sectional view of the terminal device in FIG. 2, taken along line A-A, according to other implementations of the present disclosure. FIG. 9 is a partial enlarged schematic view of the terminal device at Circle VIV in FIG. 8. As illustrated in FIG. 8 and FIG. 9, a chamber wall between the fourth surface 142 and the second surface 112 has a reflective structure 143 facing the receiver 3. Once the sound signals S1 is generated at the receiver 3, the sound signals S1 of the receiver 3 are reflected by the reflective structure to pass through the notch 1121 and reach the bottom 1111a of the groove 1111, and then reflected to the outside by the bottom 1 1 11a of the groove 1111. As an implementation, the reflective structure 143 may be an inclined surface which is gradually inclined toward the second surface 112. The bottom 1111a of the groove 1111 is inclined toward an upper right direction in FIG. 9. The reflective structure 143 is also gradually inclined toward the upper right direction in FIG. 9. An inclined direction of the reflective structure 143 matches an inclined direction of the bottom 1111a of the groove 1111, such that the reflective structure 143 and the bottom 1111a of the groove 1111 form at least two reflective surfaces for reflecting the sound signals. Specifically, the reflective structure 143 is disposed close to the first opening a1. An orthogonal projection of the reflective structure 143 along the length direction Y of the terminal device 100 falls into the bottom 1111a of the groove 1111, such that the sound signals S1 reflected by the reflective structure 143 can reach the bottom 1111a of the groove 1111 to achieve guidance to the sound signals S1. In other words, when the sound signals S1 are reflected along the length direction Y by the reflective structure 143, the sound signals S1 can reach the bottom 1 1 1 1a of the groove 1111. The inclined surface (i.e., reflective structure 143) is gradually inclined toward the cover plate 22, as such, after the sound signals S1 pass through the third opening a3 along the first direction, the sound signals S1 of the receiver 3 will reach the inclined surface instead of reaching the second opening a2. A transmitting direction of the sound signals S1 can be changed to the length direction Y by the inclined surface, such that most of the sound signals S1 which reach the inclined surface will be transmitted along the length direction Y to reach the bottom 1111a of the groove 1111. The transmitting direction of the sound signals S1 can further be changed to the thickness direction Z by the bottom 1111a of the groove 1111, such that most of the sound signals S1 which reach the bottom 111 1a of the groove 1111 are transmitted along the thickness direction Z to the outside of the terminal device 100 to achieve the receiving function of the receiver 3. As such, the sound signals can enter the user's ear along the thickness direction Z, when the user's ear is attached to the front side surface 11 of the terminal device 100. The reflective structure 143 is disposed between the fourth surface 142 and the second surface 112, the sound signals S1 which are transmitted along the first direction can be transmitted to the bottom 1111a of the groove 1111 through a shorter pathway, such that loss of the sound signals S1 can be reduced and a better receiving function of the receiver 3 can be ensured. As other implementations, the reflective structure 143 may be detachably disposed on the chamber wall between the fourth surface 142 and the second surface 112, so as to facilitate adjusting the transmitting direction of the sound signals S1 of the receiver 3 and increase assembly flexibility of the mobile terminal 100. As other implementations, the reflective structure 143 may be a convex arc surface which protrudes toward the bottom 1111a of the groove 1111, such that more sound signals S1 can be reflected to the bottom 1111a of the groove 1111 and then be reflected to the outside of the terminal device 100 by the bottom 1111a of the groove 1111.

As illustrated in FIG. 3a, the second surface 112 is provided with a protrusion 1122 which protrudes from the second surface 112. The protrusion 1122 is located in the groove 1111. The protrusion 1122 defines a light transmitting hole 1122a for a camera to collect external light. As illustrated in FIG. 3, the cover plate 22 has a display portion 221 and a projecting portion 222. The display portion 221 is disposed on the display screen 21, and the projecting portion 222 is disposed on a side of the display portion 221 and is configured to cover the protrusion 1122. As an implementation, the protrusion 1122 has an arc outer edge. Specifically, the protrusion 1122 has a circular segment and two extension segments symmetrically disposed on two sides of the circular segment, such that the protrusion 1122 has a substantially convex slope shape. The light transmitting hole 1122a may be defined in the middle of the protrusion 1122 to occupy most of the protrusion 1122. A shape of the projecting portion 222 of the cover plate 22 matches a shape of the protrusion 1122. The surface 112 is provided with the protrusion 1122, such that a display area of the screen assembly 2, i.e., the display portion 221 on the cover plate 22, does not need to be opened, and integrity of the terminal device 100 can be ensured. In addition, the protrusion 1122 is disposed in the groove 1111, which can provide a certain protection to the protrusion 1122; in other words, when the front side surface 11 of the terminal device 100 is impacted, because the protrusion 1122 is located in the groove 1111, a direct impact can be avoided on the protrusion 1122, such that the cover plate 22 which is attached to the protrusion 1122 can be protected and the reliability of the terminal device 100 can be improved. As other implementations, the protrusion 1122 may be semicircular, trapezoidal, rectangular, teardrop-shaped, or the like.

As illustrated in FIG. 3a, the groove 1111 is divided by the protrusion 1122 into a first part and a second part. The notch 1121 may be implemented as one notch and is defined in the first part or the second part. As an implementation, the first part and the second part are substantially symmetrically disposed on two sides of the protrusion 1122 and the first part is different from the second part in that the first part defines the notch 1121. As other implementations, the notch 1121 may be implemented as two notches, one notch 1121 is defined in the first part, and the other notch 1121 is defined in the second part. Correspondingly, the receiver 3 may be implemented as two receivers, one receiver 3 corresponds to the one notch 1121, and another receiver 3 corresponds to the other notch 1121. For a relative position relationship between the receiver 3 and the notch 1121, reference can be made to foregoing descriptions, which will not be repeated here.

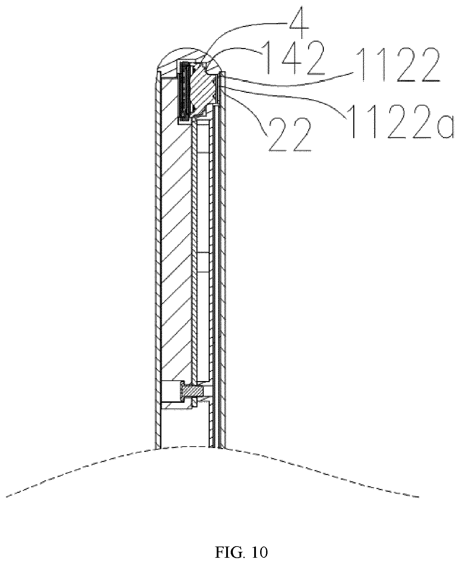

FIG. 10 is a schematic cross-sectional view of the terminal device in FIG. 2, taken along line B-B. As illustrated in FIG. 10, the terminal device further includes a front camera assembly 4 which is disposed on the fourth surface 142. The front camera assembly 4 includes a camera aligned with the light transmitting hole 1122a of the protrusion 1122, so as to collect external light via the light transmitting hole 1122a and achieve a function of taking pictures and videos. Specifically, the fourth surface 142 is provided with an accommodating portion for accommodating a lens of the camera, and the light transmitting hole 1122a extends to the accommodating portion, such that the fourth surface 142 defines a fourth opening a4. The front camera assembly 4 is disposed on the fourth surface 142, and the camera can collect the external light via the light transmitting hole 1122a by aligning with the fourth opening a4.

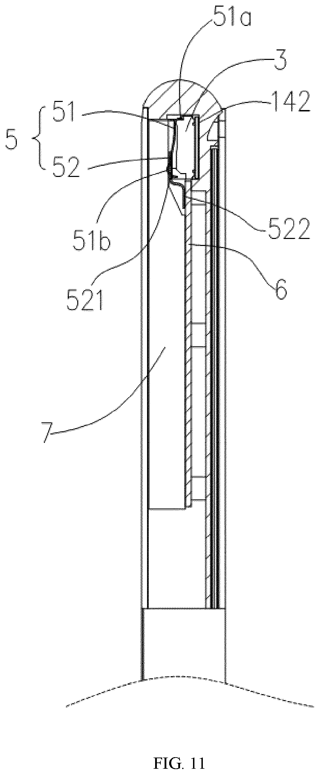

As illustrated in FIG. 11, the terminal device 100 further includes a resilient piece 5 and a mainboard 6. The receiver 3 is connected with the mainboard 6 via the resilient piece 5. The resilient piece 5 includes a first resilient piece 51 and a second resilient piece 52. The first resilient piece 51 forms a fastener 51a on one end and forms a bump 51b on the other end. The fastener 51a is fastened with a side edge of the receiver 3 and the bump 51b is attached to a surface of the receiver 3 which face away from the front sound chamber. The second resilient piece 52 includes a first resilient segment 521 and a second resilient segment 522 which is bendingly connected with the first resilient segment 521. The first resilient segment 521 abuts against with the bump 51b, the second resilient segment 522 is attached to a circuit board, such that transmission of electrical signals between the receiver 3 and the mainboard 6 can be achieved.

As illustrated in FIG. 11, the terminal device 100 further includes a press plate support 7, and the receiver 3 is fixed to the fourth surface 142 of the frame 1 via the press plate support 7. Specifically, the press plate support 7 defines a first groove and a second groove on a surface facing the circuit board, the first groove is configured to accommodate the receiver 3, and the second groove is configured to accommodate the front camera assembly 4. After the mainboard 6 is connected with the fourth surface 142 via screws, the press plate support 7 is connected with the mainboard 6 via screws, such that the receiver 3 and the front camera assembly 4 can be better fixed in the terminal device 100. The mainboard 6 defines a hollow area 61 on a top edge, such that the receiver 3 may penetrate through the hollow area 61 to align with the third opening a3 on the fourth surface 142. As an implementation, the front camera assembly 4 may also penetrate through the hollow area 61 to align with the fourth opening a4 on the fourth surface 142 through the hollow area 61. In other words, the receiver 3 and the front camera assembly 4 are adjacently disposed in the hollow area 61 of the mainboard 6, such that the mainboard 6 can accommodate the receiver 3 and the front camera assembly 4 through the only one hollow area 61. After the press plate support 7 is connected with the mainboard 6 via the screws, an end of the first resilient segment 521 of the first resilient piece 52 is located between the bottom of the first groove and the bump 51b, so as to ensure that the second resilient piece 52 abuts against the first resilient piece 51 closely. When the transmission of the electrical signals between the receiver 3 and the mainboard 6 is achieved via the resilient piece 5, the receiver 3 may be further fixed to the terminal device 100 via a combination of the resilient piece 5 and press plate support 7, such that the receiver 3 will not be easy to shift when the terminal device 100 is impacted and the reliability of the terminal device 100 can be further improved.

As illustrated in FIG. 9, when the user is making a call through the terminal device 100 provided in implementations of the present disclosure and attaching his/her to the front surface 11, after the sound signals S1 pass through the third opening a3 along the first direction, the sound signals S1 of the receiver 3 will reach the inclined surface instead of reaching the second opening a2. The transmitting direction of the sound signals S 1 can be changed to the length direction Y by the inclined surface, such that most of the sound signals S1 which reach the inclined surface will be transmitted along the length direction Y to reach the bottom 1111a of the groove 1111. The transmitting direction of the sound signals S1 can be changed to the thickness direction Z by the bottom 1111a of the groove 1111, such that most of the sound signals S1 which reach the bottom 1111a of the groove 1111 are transmitted along the thickness direction Z to the outside of the terminal device 100 to achieve the receiving function of the receiver 3. As such, the sound signals can enter the user's ear along the thickness direction Z, when the user's ear is attached to the front side surface 11 of the terminal device 100.

In the terminal device provided in implementations of the present disclosure, the screen assembly is configured to cover the notch, the frame 1 defines the groove 1111 on the top, such that the sounds of the receiver 3 can be transmitted to the outside. In addition, while a user is looking directly at the screen assembly 2 (i.e., a user is looking at the screen assembly in a thickness direction of the terminal device), because the notch 1121 is covered by the screen assembly 2, the receiver hole for the receiver to transmit the sound signals to the outside is unable to be perceived, such that the terminal device 100 has a visual effect that there is no receiver hole.

As illustrated in FIG. 3, the screen assembly 2 is also provided in implementations of the present disclosure. The screen assembly 2 includes the display screen 21 and the cover plate 22. The cover plate 22 has the display portion 221 and the projecting portion 222. The display portion 221 is disposed on the display screen 21, and the projecting portion 222 is disposed on the side of the display portion 221 and is configured to cover the sound outlet hole, for the sounds of the receiver 3 to pass through, of the frame 1. Specifically, the sound outlet hole is aligned with the second opening a2 of the second surface 112 in foregoing implementations of the terminal device 100. For a specific structure of the screen assembly 2, reference can be made to a structure of the screen assembly 2 in the foregoing implementations of the terminal device 100, which will not be repeated here.

In the screen assembly 2 provided in implementations of the present disclosure, the cover plate 22 is provided with the projecting portion 222, such that the display area of the screen assembly 2, i.e., the display portion 221 on the cover plate 22, does not need to be opened, and integrity of the display area of the screen assembly 2 can be ensured.

As illustrated in FIG. 11, the frame 1 is further provided in implementations of the present disclosure. The receiver 3 is disposed on the fourth surface 142 of the supporting plate 14 and defines the front sound chamber aligned with the sound outlet channel. Once the sound signals S1 is generated at the receiver 3, at least part of the sound signals of the receiver 3 pass through the notch 1121 and are reflected to the outside by the bottom 1111a of the groove 1111. For a specific structure of the frame 1, reference can be made to a structure of the frame 1 in the foregoing implementations of the terminal device 100, which will not be repeated here.

In the frame 1 provided in implementations of the present disclosure, the first surface 111 defines the groove 1111, such that even through the notch 1121 of the second surface 112 is covered, the sounds of the receiver 3 can still be reflected to the outside of the terminal device 100 by the bottom 1111a of the groove 1111.

## Claims

1. A terminal device (100), comprising:
a frame (1) having a front side surface (11), wherein the front side surface comprises a first surface (111) and a second surface (112) adjacent to the first surface along a thickness direction of the frame, the second surface (112) is recessed relative to the first surface, the first surface defines a groove (1111), the second surface (112) defines a notch (1121) extending through the bottom of the groove (1111), and the notch (1121) of the frame forms a sound outlet channel for sound signals of a receiver (3) to pass through.

2. The terminal device of claim 1, further comprising:
a screen assembly (2) disposed on the front side surface and covers the notch (1121) of the frame.

3. The terminal device of claim 2, further comprising:
a supporting plate (14) having a third surface (141) and a fourth surface (142) opposite to the third surface (141), wherein the third surface (141) is recessed relative to the second surface (112), and the notch (1121) extends through the supporting plate (14).

4. The terminal device of claim 3, further comprising:
the receiver (3), wherein the receiver (3) is disposed on the fourth surface (142) of the supporting plate (14), and the receiver (3) defines a front sound chamber aligned with the sound outlet channel; wherein once the sound signals are generated at the receiver (3), at least part of the sound signals of the receiver (3) pass through the notch (1121) and are reflected to the outside by the bottom of the groove (1111).

5. The terminal device of claim 4, further having a chamber wall between the fourth surface (142) and the second surface (112), wherein the chamber wall has a reflective structure (143) facing the receiver (3), and the reflective structure (143) is configured to reflect the sound signals generated by the receiver (3) to the outside.

6. The terminal device of claim 5, wherein the reflective structure (143) is an inclined surface which is gradually inclined toward the second surface (112).

7. The terminal device of claim 6, wherein an orthogonal projection of the reflective structure (143) along a length direction of the terminal device at least partially falls into the bottom of the groove (1111).

8. The terminal device of claim 5, wherein the reflective structure (143) is detachably disposed on the chamber wall between the fourth surface (142) and the second surface (112).

9. The terminal device of claim 5, wherein the reflective structure (143) is a convex arc surface which protrudes toward the bottom of the groove (1111).

10. The terminal device of any of claims 1 to 9, wherein the bottom of the groove (1111) is a concave arc surface.

11. The terminal device of any of claims 2 to 9, wherein the screen assembly (2) comprises a display screen (21) and a cover plate (22), the display screen (21) is disposed on the third surface (141), and the cover plate (22) is disposed on the second surface (112) and covers the notch (1121).

12. The terminal device of claim 11, wherein the second surface (112) is provided with a protrusion (1122), the protrusion (1122) is located in the groove (1111) and defines a light transmitting hole for a camera to collect external light, the cover plate (22) has a display portion (221) and a projecting portion (222), the display portion (221) is disposed on the display screen (21), and the projecting portion (222) is disposed on a side of the display portion and covers the protrusion (1122).

13. The terminal device of claim 12, wherein the groove (1111) is divided by the protrusion (1122) into a first part and a second part, the notch (1121) is implemented as one notch (1121), and the notch (1121) is defined in the first part or the second part.

14. A screen assembly configured for use with the terminal device of claim 1, comprising:
a display screen (21); and
a cover plate (22) having a display portion (221) and a projecting portion (222),
wherein the display portion (221) is disposed on the display screen (21), the projecting portion (222) is disposed on a side of the display portion (221) and covers a sound outlet channel of the frame (1) of the terminal device for sounds of a receiver (3) to pass through.

## Patentansprüche

1. Endgerät (100), das Folgendes umfasst:
eine Rahmen (1) mit einer vorderen Seitenoberfläche (11), wobei die vordere Seitenoberfläche eine erste Oberfläche (111) und eine zweite Oberfläche (112) angrenzend an die erste Oberfläche entlang einer Dickenrichtung des Rahmens umfasst, wobei die zweite Oberfläche (112) relativ zur ersten Oberfläche eingesenkt ist, wobei die erste Oberfläche eine Nut (1111) definiert, die zweite Oberfläche (112) eine Kerbe (1121) definiert, die sich durch den Boden der Nut (1111) erstreckt, und wobei die Kerbe (1121) des Rahmens einen Klangausgangskanal bildet, durch den Klangsignale eines Empfängers (3) passieren können.

2. Endgerät nach Anspruch 1, das ferner Folgendes umfasst:
eine Schirmanordnung (2), angeordnet an der vorderen Seitenoberfläche, die die Kerbe (1121) des Rahmens abdeckt.

3. Endgerät nach Anspruch 2, das ferner Folgendes umfasst:
eine Stützplatte (14) mit einer dritten Oberfläche (141) und einer vierten Oberfläche (142) gegenüber der dritten Oberfläche (141), wobei die dritte Oberfläche (141) relativ zur zweiten Oberfläche (112) eingesenkt ist und wobei sich die Kerbe (1121) durch die Stützplatte (14) erstreckt.

4. Endgerät nach Anspruch 3, das ferner Folgendes umfasst:
den Empfänger (3), wobei der Empfänger (3) an der vierten Oberfläche (142) der Stützplatte (14) angeordnet ist und der Empfänger (3) eine vordere Klangkammer definiert, die mit dem Klangauslasskanal ausgerichtet ist; wobei, sobald die Klangsignale am Empfänger (3) erzeugt werden, zumindest ein Teil der Klangsignale des Empfängers (3) die Kerbe (1121) passiert und durch den Boden der Nut (1111) zur Außenseite reflektiert wird.

5. Endgerät nach Anspruch 4, ferner eine Kammerwand zwischen der vierten Oberfläche (142) und der zweiten Oberfläche (112) aufweisend, wobei die Kammerwand eine reflektierende Struktur (143) aufweist, die zum Empfänger (3) zeigt, und wobei die reflektierende Struktur (143) ausgelegt ist zum Reflektieren der durch den Empfänger (3) erzeugten Klangsignale zur Außenseite.

6. Endgerät nach Anspruch 5, wobei die reflektierende Struktur (143) eine geneigte Oberfläche ist, die allmählich in Richtung der zweiten Oberfläche (112) geneigt ist.

7. Endgerät nach Anspruch 6, wobei eine orthogonale Projektion der reflektierenden Struktur (143) entlang einer Längenrichtung des Endgeräts zumindest teilweise in den Boden der Nut (1111) fällt.

8. Endgerät nach Anspruch 5, wobei die reflektierende Struktur (143) lösbar an der Kammerwand zwischen der vierten Oberfläche (142) und der zweiten Oberfläche (112) angeordnet ist.

9. Endgerät nach Anspruch 5, wobei die reflektierende Struktur (143) eine konvexe Bogenoberfläche ist, die in Richtung des Bodens der Nut (1111) herausragt.

10. Endgerät nach einem der Ansprüche 1 bis 9, wobei der Boden der Nut (1111) eine konkave Bogenoberfläche ist.

11. Endgerät nach einem der Ansprüche 2 bis 9, wobei die Schirmanordnung (2) einen Anzeigebildschirm (21) und eine Abdeckplatte (22) umfasst, wobei der Anzeigebildschirm (21) auf der dritten Oberfläche (141) angeordnet ist und die Abdeckplatte (22) auf der zweiten Oberfläche (112) angeordnet ist und die Kerbe (1121) abdeckt.

12. Endgerät nach Anspruch 11, wobei die zweite Oberfläche (112) mit einem Vorsprung (1122) versehen ist, wobei sich der Vorsprung (1122) in der Nut (1111) befindet und ein Lichtübertragungsloch für eine Kamera zum Sammeln von externem Licht definiert, wobei die Abdeckplatte (22) einen Anzeigeteil (221) und einen herausragenden Teil (222) aufweist, wobei der Anzeigeteil (221) am Anzeigebildschirm (21) angeordnet ist und der herausragende Teil (222) an einer Seite des Anzeigeteils angeordnet ist und den Vorsprung (1122) abdeckt.

13. Endgerät nach Anspruch 12, wobei die Nut (1111) durch den Vorsprung (1122) in einen ersten Teil und einen zweiten Teil geteilt wird, wobei die Kerbe (1121) als eine Kerbe (1121) umgesetzt ist und die Kerbe (1121) im ersten Teil oder im zweiten Teil definiert ist.

14. Schirmanordnung, ausgelegt zur Verwendung mit dem Endgerät nach Anspruch 1, die Folgendes umfasst:
einen Anzeigebildschirm (21); und
eine Abdeckplatte (22) mit einem Anzeigeteil (221) und einem herausragenden Teil (222),
wobei der Anzeigeteil (221) am Anzeigebildschirm (21) angeordnet ist, der herausragende Teil (222) an einer Seite des Anzeigeteils (221) angeordnet ist und einen Klangauslasskanal des Rahmens (1) des Endgeräts abdeckt, durch den Klänge eines Empfängers (3) passieren können.

## Revendications

1. Dispositif de terminal (100), comprenant :
un cadre (1) ayant une surface latérale avant (11), dans lequel la surface latérale avant comprend une première surface (111) et une deuxième surface (112) adjacente à la première surface le long d'une direction d'épaisseur du cadre, la deuxième surface (112) est en retrait relativement à la première surface, la première surface définit une rainure (1111), la deuxième surface (112) définit une encoche (1121) s'étendant à travers le fond de la rainure (1111), et l'encoche (1121) du cadre forme un canal de sortie sonore pour que des signaux sonores d'un récepteur (3) passent à travers.

2. Dispositif de terminal selon la revendication 1, comprenant en outre :
un ensemble à écran (2) disposé sur la surface latérale avant et couvrant l'encoche (1121) du cadre.

3. Dispositif de terminal selon la revendication 2, comprenant en outre :
une plaque de support (14) ayant une troisième surface (141) et une quatrième surface (142) opposée à la troisième surface (141), dans lequel la troisième surface (141) est en retrait relativement à la deuxième surface (112), et l'encoche (1121) s'étend à travers la plaque de support (14).

4. Dispositif de terminal selon la revendication 3, comprenant en outre :
le récepteur (3), dans lequel le récepteur (3) est disposé sur la quatrième surface (142) de la plaque de support (14), et le récepteur (3) définit une chambre sonore avant alignée avec le canal de sortie sonore ; dans lequel une fois que les signaux sonores sont générés, au récepteur (3), au moins une partie des signaux sonores du récepteur (3) passent à travers l'encoche (1121) et sont réfléchis vers l'extérieur par le fond de la rainure (1111).

5. Dispositif de terminal selon la revendication 4, ayant en outre une paroi de chambre entre la quatrième surface (142) et la deuxième surface (112), dans lequel la paroi de chambre a une structure réfléchissante (143) faisant face au récepteur (3), et la structure réfléchissante (143) est configurée pour réfléchir les signaux sonores générés par le récepteur (3) vers l'extérieur.

6. Dispositif de terminal selon la revendication 5, dans lequel la structure réfléchissante (143) est une surface inclinée qui est progressivement inclinée vers la deuxième surface (112).

7. Dispositif de terminal selon la revendication 6, dans lequel une saillie orthogonale de la structure réfléchissante (143) le long d'une direction de longueur du dispositif de terminal arrive au moins partiellement dans le fond de la rainure (1111).

8. Dispositif de terminal selon la revendication 5, dans lequel la structure réfléchissante (143) est disposée de façon détachable sur la paroi de chambre entre la quatrième surface (142) et la deuxième surface (112).

9. Dispositif de terminal selon la revendication 5, dans lequel la structure réfléchissante (143) est une surface arquée convexe qui est proéminente vers le fond de la rainure (1111).

10. Dispositif de terminal selon l'une quelconque des revendications 1 à 9, dans lequel le fond de la rainure (1111) est une surface arquée concave.

11. Dispositif de terminal selon l'une quelconque des revendications 2 à 9, dans lequel l'ensemble à écran (2) comprend un écran d'affichage (21) et une plaque couvercle (22), l'écran d'affichage (21) est disposé sur la troisième surface (141), et la plaque couvercle (22) est disposée sur la deuxième surface (112) et couvre l'encoche (1121).

12. Dispositif de terminal selon la revendication 11, dans lequel la deuxième surface (112) est pourvue d'une proéminence (1122), la proéminence (1122) est située dans la rainure (1111) et définit un trou de transmission de lumière pour qu'une caméra collecte de la lumière externe, la plaque couvercle (22) a une portion d'affichage (221) et une portion saillante (222), la portion d'affichage (221) est disposée sur l'écran d'affichage (21), et la portion saillante (222) est disposée sur un côté de la portion d'affichage et couvre la proéminence (1122).

13. Dispositif de terminal selon la revendication 12, dans lequel la rainure (1111) est divisée par la proéminence (1122) en une première partie et une seconde partie, l'encoche (1121) est exécutée sous la forme d'une encoche (1121), et l'encoche (1121) est définie dans la première partie ou la seconde partie.

14. Ensemble à écran configuré pour l'utilisation avec le dispositif de terminal selon la revendication 1, comprenant :
un écran d'affichage (21) ; et
une plaque couvercle (22) ayant une portion d'affichage (221) et une portion saillante (222),
dans lequel la portion d'affichage (221) est disposée sur l'écran d'affichage (21), la portion saillante (222) est disposée sur un côté de la portion d'affichage (221) et couvre un canal de sortie sonore du cadre (1) du dispositif de terminal pour que des sons d'un récepteur (3) passent à travers.
